# EUROPEAN PATENT SPECIFICATION

(11) **EP 2 104 588 B1**
(45) Date of publication and mention of the grant of the patent: **21.11.2012**
(21) Application number: 08702638.1
(22) Date of filing: 14.01.2008
(51) Int. Cl.: B23P 19/04, H03K 17/96

(54) **A METHOD FOR THE FULLY AUTOMATED PRODUCTION OF A PIEZOELECTRIC SWITCH AND A PROCESS THEREFOR**
VERFAHREN ZUR VOLLAUTOMATISCHEN HERSTELLUNG EINES PIEZOELEKTRISCHEN SCHALTERS UND PROZESS DAFÜR
PROCÉDÉ POUR LA PRODUCTION ENTIÈREMENT AUTOMATISÉE D'UN COMMUTATEUR PIÉZOÉLECTRIQUE ET SON PROCESSUS

(30) Priority: 15.01.2007 IL 18071507
(43) Date of publication of application: 30.09.2009
(73) Proprietor: Baran Advanced Technologies (86) Ltd., 85965 Industrial Park, Omer (IL)
(72) Inventor: ROSENBERG, Armand, 76468 Rehovot (IL)
(74) Representative: Tiesmeyer, Johannes
(86) International application number: PCT/IL2008/000057
(87) International publication number: WO 2008/087630

(56) References cited:
- EP-A1- 0 553 881
- EP-A2- 0 343 685
- US-A- 3 660 602
- US-A- 4 430 595
- US-A- 5 349 263
- US-A- 6 064 141
- US-B1- 6 199 429
- US-B1- 6 310 428

## Description

### Field of the Invention

The present invention relates to the field of producing piezoelectric switches. More particularly, the invention relates to a method for assembling piezoelectric switches which is fully automated, simple and cost effective.

### Background of the invention

In contrary to conventional mechanical switches which depend upon freedom of motion of at least one component, the piezoelectric switches may be constructed with no moving parts, a feature that enhances the life span of the switch in many ways. Firstly, the switch components are less likely to wear off from friction of movement. Secondly, the switches may be hermetically sealed against environmental changes, vandalism, and cleaning liquids. When pressure is applied to the outer deformable surface of the piezoelectric switch, the pressure is transferred to the piezoelectric material, which in turn produces a potential for activating the switching circuit. Upon activation, the switching circuit produces an electric connection between its two ports, effectively closing the outer electric circuit where the switch is connected. Nevertheless, since the piezoelectric switches must be pressure sensitive, their construction usually requires a tight assembly of their inner components. Therefore, some of the prior art piezoelectric switches comprise a rigid outer cup-shaped casing where all the inner components are inserted inside, with great precision, and tightly fastened, a complex process which in effect raises manufacturing costs. In some of the cases the piezoelectric switches are injected with a relatively rigid insulating substance for transferring the pressure from the deformable surface to the piezoelectric material, a process which also raises manufacturing costs. Therefore, a method is needed for assembling simple piezoelectric switches, where the assembly is fully automated, simple and, cost effective.

US patent 4,896,069 discloses a piezoelectric switch which includes a cup-shaped casing, a piezoelectric ceramic for sensing the external mechanical force applied on the casing and converting the force to an electrical signal, a conductive rubber connector disposed adjacent to and in contact with the ceramic for conducting the electrical signal, and a PCB (Printed Circuit Board) disposed adjacent to and in contact with the conductive member for receiving and processing the conducted electrical signal received from the piezoelectric ceramic. Nevertheless, the disclosed switch requires a precise assembly and a tight seal which is costly to manufacture. Furthermore, each piezoelectric switch requires a separate assembly and a specially cut individual circuit for inserting in the cup-shaped casing.

US patent 5,231,326 discloses a push button piezoelectric switch which does not produce false switching caused by fast temperature rise. The piezoelectric transducer is connected to the switching circuit with a polarity to provide a switching voltage in response to actuation of the push button switch by finger pressure. The connection is such that the polarity of the voltage generated as a result of differential thermal expansion of the piezoelectric transducer is opposite to that produced by finger pressure on the push button switch and does not produce false switching caused by fast temperature rise. In addition, the switch is injected with a thermal insulating material between the outer surface and the piezoelectric transducer. Nevertheless, the disclosed switch is difficult and costly to manufacture.

Further examples of prior art piezoelectric switches are disclosed in US 6,064,141 A and EP 0343685 A2.

It is an object of the present invention to provide a method for a simple assembly of a piezoelectric switch.

It is another object of the present invention to provide a method for fully automated manufacturing of piezoelectric switches.

It is still another object of the present invention to provide a method for manufacturing piezoelectric switches which are cost effective and use a minimal number of parts.

It is still another object of the present invention to provide a method for manufacturing piezoelectric switches which do not require unnecessary insulating materials.

Other objects and advantages of the invention will become apparent as the description proceeds.

### Summary of the Invention

The present invention relates to a method for fully automated production of a piezoelectric switch, comprising the steps of: (a) providing a pliable metal sheet, suitable to flex under pressure; (b) providing and attaching to said metal sheet a piezoelectric ceramic element, which is capable of developing an electric potential under pressure; (c) providing a conductive elastomeric element juxtaposed to and in contact on one side with said piezoelectric ceramic element; (d) providing a switching circuit, printed in a PCB, having two electrically disconnected ports, said PCB being juxtaposed to and in contact with the other side of said conductive elastomeric element; and (e) bending said metal sheet in order to cover inner components of said switch, characterized in that said step of bending said metal sheet is carried out by bending both sides along the length of said metal sheet to clamp over said PCB, to create a sandwich-like structure enclosing and protecting said piezoelectric ceramic element, said conductive elastomeric element and said switching circuit, so that pressure will be transferred to said piezoelectric ceramic element, when finger pressure is applied to said metal sheet, thereby producing an electric potential for interconnecting said switch.

Preferably, the piezoelectric ceramic element is positioned off-center of the pliable metal sheet.

Preferably, more than one piezoelectric switch is produced on a PCB slider.

The invention further relates to a piezoelectric switch, comprising: (a) a pliable metal sheet suitable to flex under pressure; (b) attached to said metal sheet, a piezoelectric ceramic element, which is capable of developing an electric potential under pressure; (c) a conductive elastomeric element juxtaposed to and in contact on one side with said piezoelectric ceramic element; and (d) a switching circuit, printed in a PCB, having two electrically disconnected ports, said PCB being juxtaposed to and in contact with the other side of said conductive elastomeric element, characterized in that both sides of said pliable metal sheet are bent along its length to clamp over said PCB, to create a sandwich-like structure enclosing and protecting said piezoelectric ceramic element, said conductive elastomeric element and said switching circuit, so that pressure will be transferred to said piezoelectric ceramic element, when finger pressure is applied to said metal sheet, thereby producing an electric potential for interconnecting said switch.

Preferably, the piezoelectric ceramic element is positioned off-center of the pliable metal sheet.

### Brief Description of the Drawings

In the drawings:
- Fig. 1a is a spread view of the piezoelectric switch and its components according to one of the embodiments of the invention.
- Fig. 1b is an exploded view of the piezoelectric switch according to one of the embodiments of the invention.
- Fig. 2 is a perspective view of the assembled piezoelectric switch according to one of the embodiments.
- Fig. 3 is a perspective view of an array of assembled piezoelectric switches mounted on a PCB slider according to one of the embodiments.
- Fig. 4a is a spread view of a piezoelectric switch and its components according to one of the embodiments.
- Fig. 4b is an exploded view of the piezoelectric switch according to one of the embodiments.

### Detailed Description of Preferred Embodiments

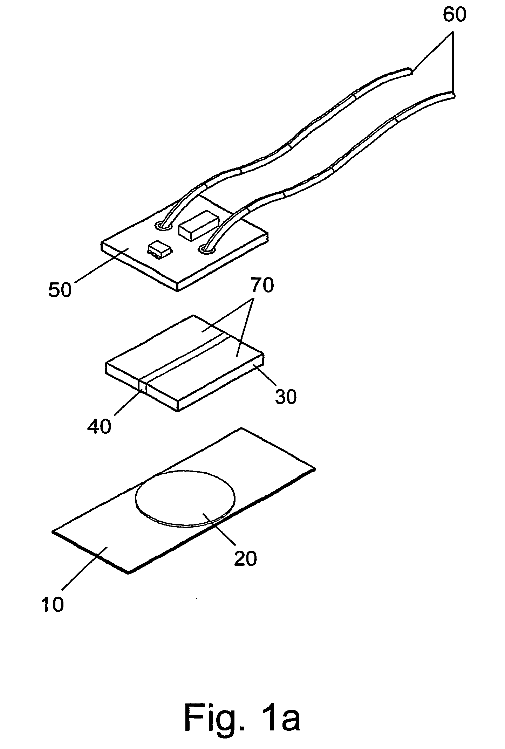

Fig. 1a is a spread view of the piezoelectric switch and its components according to one of the embodiments of the invention. The first component of the piezoelectric switch is a metal foil sheet 10 which is sufficiently flexible to yield under light finger pressure. The second component is a piezoelectric ceramic 20, which is attached to the metal sheet 10, capable of producing an electric potential under light finger pressure, where the light finger pressure is determined as a statistical factor derived from the light finger pressure applied by the general public, or a test group representative of the general population. The third component is a conductive elastomer 30 which is formed as a sandwich, in which a conductive portion 40 is layered between two insulating layers 70. The conductive portion 40 is constructed from strips of conductive material alternating with strips of insulating material, in order to transfer electric potential between upper side and lower side of the conductive elastomer 30. The forth component is the switch circuit printed on PCB 50 which, upon receiving electrical potential, abridges connecting wires 60, effectively causing electrical connectivity between the wires 60. The wires 60 may be external wires attached to PCB 50, as shown, or conducting wires printed on PCB 50 according to one of the embodiments. The wires or any other connecting arrangement is referred to hereinafter as ports.

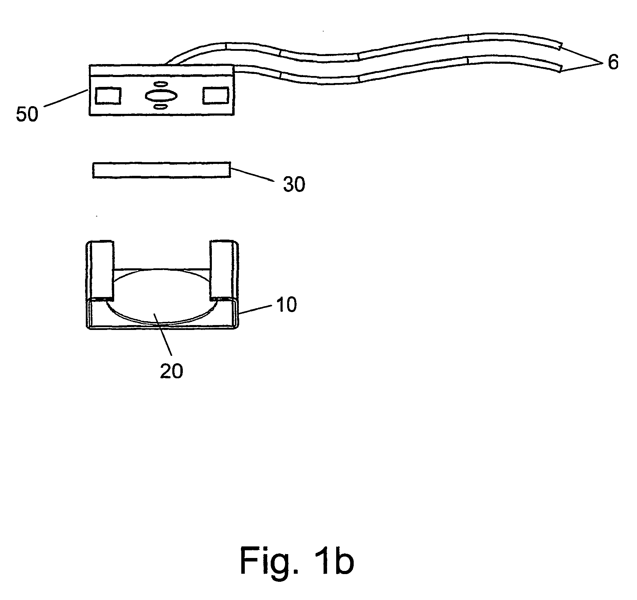

Fig. 1b is an exploded view of the piezoelectric switch according to one of the embodiments of the invention. The automatic assembly of the piezoelectric switch is described in relations to Fig. 1a and begins by providing a metal foil sheet 10. The provided metal foil sheet 10 should have enough width to cover the piezoelectric ceramic 20 and conductive elastomer 30, whereas its length should be long enough to bend around the PCB 50, as shown in Fig. 1b. Next, a piezoelectric ceramic 20 is attached or glued to the metal foil sheet 10 in the area designated to receive the impact of light finger pressure applied to the other side of the metal foil sheet 10. Conductive elastomer 30 is then provided for placing on the piezoelectric ceramic 20, which in turn is responsible for conducting the electric potential of the piezoelectric ceramic 20 to the switching circuit on PCB 50. All three components: metal foil sheet 10, piezoelectric ceramic 20, and conductive elastomer 30, are thus placed on PCB 50 and securely fastened to PCB 50 by bending both sides of metal foil 10 to clamp over the PCB 50, effectively enclosing the piezoelectric ceramic 20 and elastomer 30 inside. Thus when the light finger pressure is applied to metal foil sheet 10 from the outer side, the pressure is transferred to the piezoelectric ceramic 20 which in turn produces an electric potential. The electric potential is then conducted by the conductive elastomer 30 to circuit 50, which in turn abridges the gap between connecting ports 60, effectively interconnecting the switch.

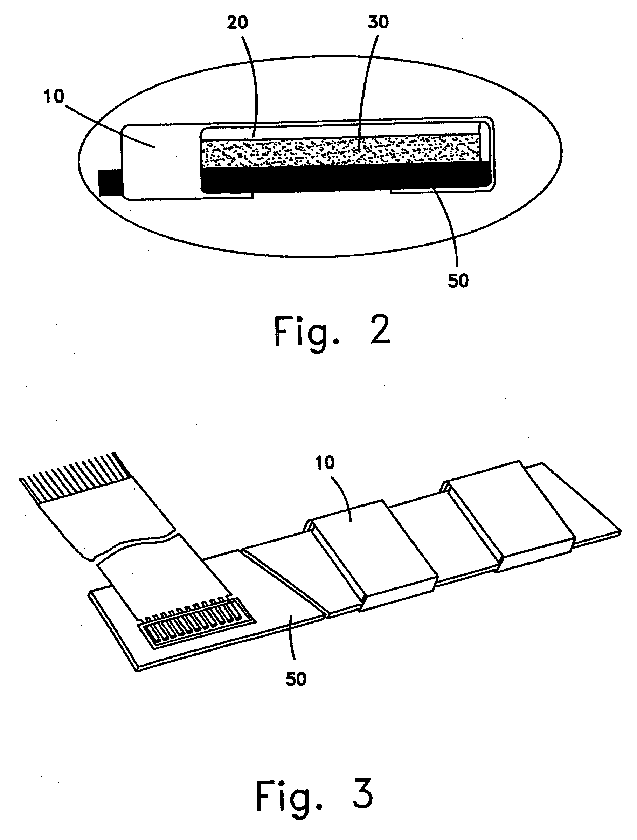

Fig. 2 is a perspective view of the assembled piezoelectric switch according to one of the embodiments. The metal foil sheet 10 is bended on both sides in order to cover and protect the inner components of the piezoelectric switch. Inside the protection of the metal foil sheet 10 are the piezoelectric ceramic 20 which is attached under the metal sheet 10, the conductive elastomer 30, and the switch circuit on PCB 50.

Fig. 3 is a perspective view of an array of assembled piezoelectric switches mounted on a PCB slider according to one of the embodiments. In this embodiment a number of piezoelectric switches, each having its own metal foil sheet covering 10, are mounted on a single PCB slider 50 in an automated process, as described in relation to Fig. 1b, and the switches connect between conductive ports printed in the PCB 50. The PCB slider may have a single printed circuit having a number of switches each having its own metal foil sheet 10 enclosing the inner parts of the switch.

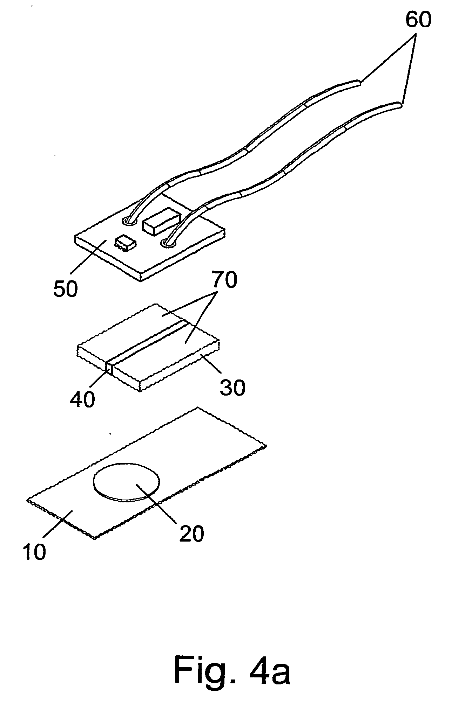

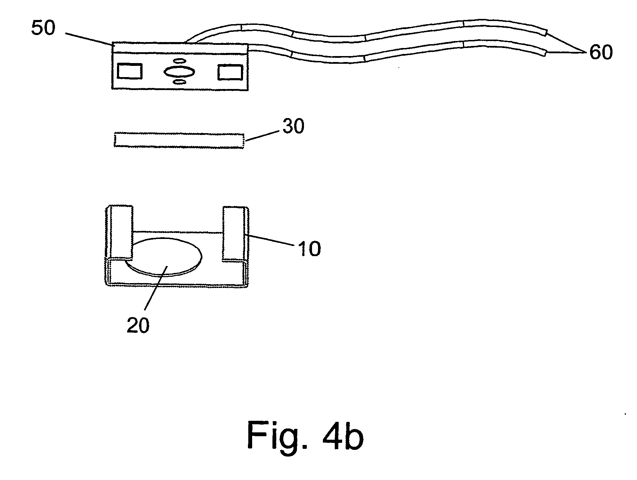

Fig. 4a is a spread view of another piezoelectric switch and its components according to one of the embodiments, and Fig. 4b is an exploded view of the same piezoelectric switch. In this embodiment the piezoelectric ceramic 20 is positioned off-center of the metal foil sheet 10. Eventually, at the end of the assembly, the piezoelectric ceramic 20 is bound to be closer to one of the foil sheet 10 bended sides. The proximity of the piezoelectric ceramic 20 to one of the bended sides of the foil sheet 10 causes the piezoelectric ceramic 20 to produce an electric potential even when softer pressures than light finger pressures are applied, thus improving the sensitiveness of the switch. The rest of the switch components are similar to the components described before in relations to Fig. 1a and Fig. 1b.

## Claims

1. A method for fully automated production of a piezoelectric switch, comprising the steps of:
a. providing a pliable metal sheet (10), suitable to flex under pressure;
b. providing and attaching to said metal sheet (10) a piezoelectric ceramic element (20), which is capable of developing an electric potential under pressure;
c. providing a conductive elastomeric element (30) juxtaposed to and in contact on one side with said piezoelectric ceramic element (20);
d. providing a switching circuit, printed in a PCB (50), having two electrically disconnected ports, said PCB (50) being juxtaposed to and in contact with the other side of said conductive elastomeric element (30); and
e. bending said metal sheet (10) in order to cover inner components of said switch,
**characterized in that** said step of bending said metal sheet (10) is carried out by bending both sides along the length of said metal sheet (10) to clamp over said PCB (50), to create a sandwich-like structure enclosing and protecting said piezoelectric ceramic element (20), said conductive elastomeric element (30) and said switching circuit, so that pressure will be transferred to said piezoelectric ceramic element (20), when finger pressure is applied to said metal sheet (10), thereby producing an electric potential for interconnecting said switch.

2. A method according to claim 1, where the piezoelectric ceramic element (20) is positioned off-center of the pliable metal sheet (10).

3. A method according to claim 1, where more than one piezoelectric switch is produced on a PCB slider (50).

4. A piezoelectric switch, comprising:
a. a pliable metal sheet (10) suitable to flex under pressure;
b. attached to said metal sheet (10), a piezoelectric ceramic element (20), which is capable of developing an electric potential under pressure;
c. a conductive elastomeric element (30) juxtaposed to and in contact on one side with said piezoelectric ceramic element (20); and
d. a switching circuit, printed in a PCB (50), having two electrically disconnected ports, said PCB (50) being juxtaposed to and in contact with the other side of said conductive elastomeric element (30),
**characterized in that** both sides of said pliable metal sheet (10) are bent along its length to clamp over said PCB (50), to create a sandwich-like structure enclosing and protecting said piezoelectric ceramic element (20), said conductive elastomeric element (30) and said switching circuit, so that pressure will be transferred to said piezoelectric ceramic element (20), when finger pressure is applied to said metal sheet (10), thereby producing an electric potential for interconnecting said switch.

5. A switch according to claim 4, where the piezoelectric ceramic element (20) is positioned off-center of the pliable metal sheet (10).

6. A switch according to claim 4, where the metal sheet (10) is a metal foil sheet.

7. A switch according to claim 4, wherein the metal sheet (10), the piezoelectric ceramic element (20) and the conductive elastomeric element (30) are securely fastened to the PCB (50).

## Patentansprüche

1. Verfahren zum vollständig automatisierten Herstellen eines piezoelektrischen Schalters, umfassend die Schritte:
a. Bereitstellen eines biegsamen Metallbleches (10), welches dazu geeignet ist, sich unter Druck zu biegen;
b. Bereitstellen und Anbringen eines piezoelektrischen keramischen Elementes (20), welches dazu fähig ist, ein elektrisches Potential unter Druck zu entwickeln, an das Metallblech (10);
c. Bereitstellen eines leitfähigen Elastomerelements (30), welches neben und in Kontakt an einer Seite mit dem piezoelektrischen keramischen Element (20) ist;
d. Bereitstellen eines in eine Leiterplatte (PCB) (50) gedruckten Schaltschaltkreises, welcher zwei elektrisch getrennte Anschlüsse aufweist, wobei die Leiterplatte (50) neben und in Kontakt mit der anderen Seite des leitfähigen Elastomerelements (30) ist; und
e. Biegen des Metallbleches (10), um die inneren Komponenten des Schalters abzudecken,
**dadurch gekennzeichnet, dass** der Schritt des Biegens des Metallbleches (10) durch Biegen beider Seiten entlang der Länge des Metallbleches (10) zum Umklammern der Leiterplatte (50) ausgeführt wird, um eine sandwichartige Struktur zu erzeugen, welche das piezoelektrische keramische Element (20), das leitfähige Elastomerelement (30) und den Schaltschaltkreis umschließt und schützt, so dass Druck auf das piezoelektrische keramische Element (20) übertragen wird, wenn Fingerdruck auf das Metallblech (10) ausgeübt wird, wodurch ein elektrisches Potential zum Zwischenschalten des Schalters erzeugt wird.

2. Verfahren nach Anspruch 1, wobei das piezoelektrische keramische Element (20) exzentrisch von dem biegsamen Metallblech (10) angeordnet ist.

3. Verfahren nach Anspruch 1, wobei mehr als ein piezoelektrischer Schalter auf einem Leiterplattenschieber (50) hergestellt wird.

4. Piezoelektrischer Schalter, umfassend:
a. ein biegsames Metallblech (10), welches dazu geeignet ist, sich unter Druck zu biegen;
b. ein an dem Metallblech (10) angebrachtes piezoelektrisches keramisches Element (20), welches dazu fähig ist, ein elektrisches Potential unter Druck zu entwickeln;
c. ein leitfähiges Elastomerelement (30), welches neben und in Kontakt an einer Seite mit dem piezoelektrischen keramischen Element (20) ist; und
d. ein in einer Leiterplatte (50) gedruckter Schaltschaltkreis, welcher zwei elektrisch getrennte Anschlüsse aufweist, wobei die Leiterplatte (50) neben und in Kontakt mit der anderen Seite des leitfähigen Elastomerelements (30) ist,
**dadurch gekennzeichnet, dass** beide Seiten des biegsamen Metallbleches (10) entlang seiner Länge gebogen sind, um die Leiterplatte (50) zu umklammern, um eine sandwichartige Struktur zu erzeugen, welche das piezoelektrische keramische Element (20), das leitfähige Elastomerelement (30) und den Schaltschaltkreis umschließt und schützt, so dass Druck auf das piezoelektrische keramische Element (20) übertragen wird, wenn Fingerdruck auf das Metallblech (10) ausgeübt wird, wodurch ein elektrisches Potential zum Zwischenschalten des Schalters erzeugt wird.

5. Schalter nach Anspruch 4, wobei das piezoelektrische keramische Element (20) exzentrisch von dem biegsamen Metallblech (10) angeordnet ist.

6. Schalter nach Anspruch 4, wobei das Metallblech (10) ein Metallfolienblech ist.

7. Schalter nach Anspruch 4, wobei das Metallblech (10), das piezoelektrische keramische Element (20) und das leitfähige Elastomerelement (30) sicher an der Leiterplatte (50) befestigt sind.

## Revendications

1. Procédé de production entièrement automatisée d'un commutateur piézoélectrique, comprenant les étapes de:
a. fournir une feuille métallique pliable (10), convenant pour la flexion sous pression;
b. fournir et attacher à ladite feuille métallique (10) un élément céramique piézoélectrique (20) qui est capable de développer un potentiel électrique sous pression;
c. fournir un élément conducteur élastomère (30) juxtaposé à et en contact d'un côté avec ledit élément céramique piézoélectrique (20);
d. fournir un circuit de commutation, imprimé sur une carte de circuits imprimés (50), ayant deux ports déconnectés électriquement, ladite carte de circuits imprimés (50) étant juxtaposée à et en contact avec l'autre côté dudit élément conducteur élastomère (30); et
e. plier ladite feuille métallique (10) afin de recouvrir les composants intérieurs dudit interrupteur,
**caractérisé en ce que** ladite étape de flexion de ladite feuille métallique (10) est exécutée en pliant les deux côtés le long de la longueur de ladite feuille métallique (10) pour la pincer sur ladite carte de circuits imprimés (50), afin de créer une structure en sandwich enfermant et protégeant ledit élément céramique piézoélectrique (20), ledit élément conducteur élastomère (30) et ledit circuit de commutation, de sorte que la pression soit transférée audit élément céramique piézoélectrique (20) lorsqu'une pression des doigts est appliquée sur ladite feuille métallique (10), produisant ce faisant un potentiel électrique pour l'interconnexion dudit interrupteur.

2. Procédé suivant la revendication 1, dans lequel l'élément céramique piézoélectrique (20) est positionné décentré par rapport à la feuille métallique pliable (10).

3. Procédé suivant la revendication 1, dans lequel plus d'un interrupteur piézoélectrique est produit sur une carte de circuits imprimés coulissante (50).

4. Interrupteur piézoélectrique, comprenant:
a. une feuille métallique pliable (10), convenant pour la flexion sous pression;
b. un élément céramique piézoélectrique (20) attaché à ladite feuille métallique (10), lequel est capable de développer un potentiel électrique sous pression;
c. un élément conducteur élastomère (30) juxtaposé à et en contact d'un côté avec ledit élément céramique piézoélectrique (20); et
d. un circuit de commutation, imprimé sur une carte de circuits imprimés (50), ayant deux ports déconnectés électriquement, ladite carte de circuits imprimés (50) étant juxtaposée à et en contact avec l'autre côté dudit élément conducteur élastomère (30),
**caractérisé en ce que** les deux côtés de ladite feuille métallique pliable (10) sont repliés le long de sa longueur pour pincer sur ladite carte de circuits imprimés (50), afin de créer une structure en sandwich enfermant et protégeant ledit élément céramique piézoélectrique (20), ledit élément conducteur élastomère (30) et ledit circuit de commutation, de sorte que la pression soit transférée audit élément céramique piézoélectrique (20) lorsqu'une pression des doigts est appliquée sur ladite feuille métallique (10), produisant ce faisant un potentiel électrique pour l'interconnexion dudit interrupteur.

5. Interrupteur suivant la revendication 4, dans lequel l'élément céramique piézoélectrique (20) est positionné décentré par rapport à la feuille métallique pliable (10).

6. Interrupteur suivant la revendication 4, dans lequel la feuille métallique (10) est une feuille de clinquant métallique.

7. Interrupteur suivant la revendication 4, dans lequel la feuille métallique (10), l'élément céramique piézoélectrique (20) et l'élément conducteur élastomère (30) sont fixés de manière sûre à la carte de circuits imprimés (50).
